# EUROPÄISCHE PATENTSCHRIFT

(11) **EP 0 615 672 B1**
(45) Veröffentlichungstag und Bekanntmachung des Hinweises auf die Patenterteilung: **04.03.1998**
(21) Anmeldenummer: 93921878.0
(22) Anmeldetag: 29.09.1993
(51) Int. Cl.: H04H 1/00

(54) **VERFAHREN ZUR ABSTIMMUNG EINES RUNDFUNKEMPFÄNGERS UNTER VERWENDUNG DER RDS-INFORMATION**
PROCESS FOR TUNING A RADIO RECEIVER USING RDS DATA
PROCEDE DE SYNTONISATION D'UN RECEPTEUR RADIO A L'AIDE DE L'INFORMATION PAR RDS

(30) Priorität: 02.10.1992 DE 4233282
(43) Veröffentlichungstag der Anmeldung: 21.09.1994
(73) Patentinhaber: BECKER GmbH, D-76307 Karlsbad (DE)
(72) Erfinder: KLOS, Rainer, D-76275 Ettlingen (DE)
(74) Vertreter: Degwert, Hartmut, Dipl.-Phys.
(86) Internationale Anmeldenummer: EP9302648
(87) Internationale Veröffentlichungsnummer: WO9408407

(56) Entgegenhaltungen:
- EP-A- 0 498 233
- SUPPLEMENT 3 TO TECH.3244-E, EUROPEAN BROADCASTING UNION Juli 1989 , BRUSSELS, BE Seiten 1 - 3 'Specifications of the radio data system RDS for VHF/FM sound broadcasting; Programme-Type Codes'
- PATENT ABSTRACTS OF JAPAN vol. 14, no. 511 (E-0999)8. November 1990 & JP,A,02 213 229 (ALPINE ELECTRON. INC.) 24. August 1990
- PATENT ABSTRACTS OF JAPAN vol. 15, no. 86 (E-1039)28. Februar 1991 & JP,A,02 301 330 (ALPINE ELECTRON. INC.) 13. Dezember 1990
- PATENT ABSTRACTS OF JAPAN vol. 15, no. 165 (E-1061)25. April 1991 & JP,A,03 034 630 (SANYO ELECTRIC CO. LTD.) 14. Februar 1991

## Beschreibung

Die Erfindung betrifft ein Verfahren zur Abstimmung eines Rundfunkempfängers auf einen Sender einer bestimmten Programm-Art unter Verwendung der RDS-Information.

Durch die Ausnutzung der nach dem RDS (RadioDatenSystem) zur Verfügung gestellten Informationen besteht für den Benutzer eines Rundfunkempfängers prinzipiell die Möglichkeit, unter den am Empfangsort empfangbaren Sendern nur solche auszuwählen, die eine gewünschte Programm-Art ausstrahlen. Zu diesen Informationen gehört die PTY-Information (Programm-Typ-Information), die mittels einer genormten Kennzahl die Art des Programmes angibt, welches der betreffende Sender ausstrahlt, beispielsweise Nachrichtendienste, Sportsendungen, Unterhaltungsmusik oder klassische Musik.

Zur Ausnutzung der RDS-Information bei der Auswahl einer bestimmten Programm-Art muß der Benutzer am Rundfunkempfänger irgendein Bedienelement betätigen, mit dem dieser auf die gewünschte Programm-Art eingestellt wird. In Betracht kommt beispielsweise, mittels eines mehrfach zu betätigenden Tasters zwischen den verschiedenen Programm-Arten umzuschalten, wobei die jeweils eingestellte Programm-Art in einem Anzeigefeld abgelesen werden kann. Eine solche Einstellmethode mag für stationäre Rundfunkempfänger geeignet sein; bei einem mobilen Rundfunkempfänger, insbesondere Autoradio, ist sie zu langwierig und erfordert zuviel Aufmerksamkeit, da eine gezielte Auswahl ohne das Ablesen der angezeigten Programm-Art kaum möglich ist.

Ein solcher RDS-RUNDFUNKEMPFÄNGER ist z.B. aus EP-A-0 498 233 bekannt.

Das erfindungsgemäße Abstimmverfahren eignet sich besonders für mobile Rundfunkempfänger wie Autoradios, ist aber auch bei stationären Rundfunkempfängern nützlich, um die Bedienung zu vereinfachen.

Bei dem erfindungsgemäßen Verfahren zur Abstimmung eines Rundfunkempfängers auf einen Sender einer bestimmten Programm-Art unter Verwendung der RDS-Information wird zunächst der Rundfunkempfänger, beispielsweise mittels Sendersuchlaufs, auf einen beliebigen Sender eingestellt, der ein Programm sendet, das den Wünschen des Benutzers entspricht. Aus der RDS-Information, die der eingestellte Sender mit dem Programm ausstrahlt, wird dann die für die Programm-Art kennzeichnende Information (PTY-Information) gewonnen. Durch Betätigung eines zugeordneten Bedienelements wird dann ein Filter gesetzt, dessen Filterbedingung die Übereinstimmung mit dieser die Programm-Art kennzeichnenden Information ist. Bei einer anschließenden Einstellung des Rundfunkempfängers auf einen anderen Sender, beispielsweise wiederum mittels Suchlaufs, wird auch dessen die Programm-Art kennzeichnende Information gewonnen. Schließlich wird jeder anschließend eingestellte Sender nur dann als empfangbar berücksichtigt, wenn er die Filterbedingung erfüllt.

Bei diesem Verfahren muß der Benutzer die jeweils ausgewählte Programm-Art nicht kennen. Hat er beispielsweise das Filter gesetzt, während ein Sender eingestellt war, der eine Sportsendung ausstrahlt, so werden bei einem anschließenden Sendersuchlauf nur noch solche Sender angeboten, die ebenfalls eine Sportsendung ausstrahlen.

Vorzugsweise kann ein so gesetztes Filter durch erneute Betätigung des Bedienelements inaktiviert werden.

Durch das erfindungsgemäße Verfahren wird es möglich, einen Rundfunkempfänger gezielt auf eine gewünschte Programm-Art einzustellen, indem lediglich zwei Bedienelemente betätigt werden, beispielsweise eine Taste, mit der ein Sendersuchlauf gestartet wird, und eine Taste, mit der das Filter aktiviert oder deaktiviert wird. Beispielsweise kann ein Autoradio statt mit einer Vielzahl von Stationstasten mit lediglich zwei derartigen Bedienelementen ausgestattet werden, die ohne Blickkontakt leicht und schnell zu bedienen sind.

Zweckmäßig ist es, den Zustand des Filters (aktiv oder inaktiv) mittels eines gesonderten Anzeigeelements darzustellen, beispeilsweise mittels eines in eine Taste integrierten Leuchtzeichens.

Das erfindungsgemäße Verfahren eröffnet Möglichkeiten zu vorteilhaften Ausgestaltungen.

Gemäß einer ersten solchen Ausgestaltung wird in dem Rundfunkempfänger durch periodisch wiederholten oder permanent durchgeführten Sendersuchlauf eine Tabelle von Alternativsendern angelegt, in der nur solche Sender aufgenommen sind, die einer gesetzten Filterbedingung entsprechen. Der Rundfunkempfänger kann nun manuell oder automatisch, beispielsweise bei unbefriedigender Empfangsqualität, auf einen Alternativsender umgeschaltet werden.

Eine weitere Ausgestaltung besteht darin, daß am Rundfunkempfänger ein gesondertes Bedienelement, beispielsweise eine Taste mit der Aufschrift "BEST", betätigt wird, um einen Sendersuchlauf auszulösen, wobei dann von jedem gefundenen Sender, der die Filterbedingung erfüllt, die Empfangsqualität bestimmt und eine für sie kennzeichnende Bewertungsgröße mit der Senderfrequenz vorübergehend gespeichert wird, um schließlich unter den gespeicherten Senderfrequenzen diejenige zum Empfang einzustellen, deren Bewertungsgröße die beste Empfangsqualität angibt. Durch einmaliges Betätigen dieses gesonderten Bedienelements kann folglich der Benutzer den Rundfunkempfänger auf denjenigen Sender einstellen, der die gewünschte Programm-Art in der bestmöglichen Empfangsqualität anbietet.

Einzelheiten des Verfahrens werden nun unter Bezugnahme auf die Zeichnung näher beschrieben. In der Zeichnung zeigen:
- Fig. 1: die Bedienfront eines mobilen Rundfunkempfängers; und
- Fig. 2: ein schematisches Blockschaltbild eines zur Durchführung des Verfahrens geeigneten Rundfunkempfängers.

Das Verfahren wird nachstehend am Beispiel eines Autoradios beschrieben, da die durch das Verfahren erzielten Vorteile bei einem solchen Empfänger besonderes Gewicht haben.

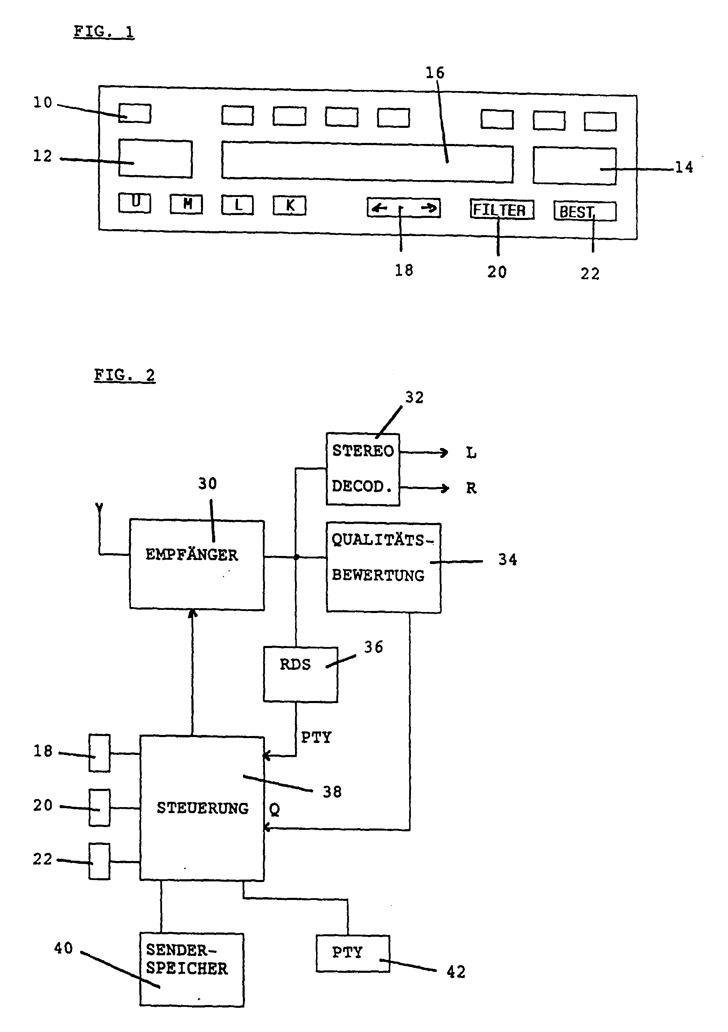

Bei der in Fig. 1 beispielshalber gezeigten Bedienfront eines Autoradios sind die verschiedenen Bedienelemente in drei übereinander angeordnete Zeilen gegliedert. In der ersten Zeile befindet sich ein Ein/Aus-Schalter, der mit 10 bezeichnet ist. Es folgen weitere Bedienelemente in Form von Tasten, auf deren Funktion hier nicht näher eingegangen wird.

In der zweiten Zeile ist zwischen zwei großflächigen Bedienelementen 12, 14 ein alphanumerisches Anzeigefeld 16 angeordnet.

In der dritten Zeile befinden sich zunächst vier Tasten für die Wellenbereiche, die mit U, M, L und K bezeichnet sind. Anschließend folgen drei weitere Tasten 18, 20 und 22. Die Taste 18 ist eine Schaltwippe und dient zur Auslösung des Sendersuchlaufs in beiden Richtungen. Die Taste 20 trägt die Beschriftung "FILTER" und dient zugleich als optisches Schauzeichen, da die Taste von innen her beleuchtet werden kann. Die dritte Taste 22 trägt den Schriftzug "BEST" und dient zur Einstellung des Rundfunkempfängers auf denjenigen Sender einer gewünschten Programm-Art, der momentan die beste Empfangsqualität liefert.

Die für das Verständnis der Erfindung wesentlichen Bestandteile des Rundfunkempfängers sind in dem Blockschaltbild der Fig. 2 veranschaulicht.

Das MPX-Ausgangssignal eines Empfängers 30 wird über einen Stereo-Decoder 32 den beiden Stereo-Wiedergabekanälen L und R zugeführt. Ferner ist das MPX-Signal an eine Qualitätsbewertungsstufe 34 angelegt. Das MPX-Signal wird schließlich an einen RDS-Decoder 36 angelegt. Die Funktionen des Empfängers 30 werden durch eine Steuerschaltung 38 gesteuert. Die den Tasten 18, 20 und 22 zugeordneten Schalter sind mit dieser Steuerschaltung 38 verbunden. Die Steuerschaltung 38 empfängt ferner aus dem RDS-Decoder 36 ein Signal, das u.a. die PTY-Information enthält, also eine Kennzahl, welche die Programm-Art nach einer etablierten Norm angibt.

Das Ausgangssignal Q der Qualitätsbewertungsstufe 34 wird ebenfalls der Steuerschaltung 38 zugeführt. Schließlich sind an die Steuerschaltung 38 ein Sender-Speicher 40 und ein Register 42 angeschlossen.

Es wird nun das mit diesem Rundfunkempfänger ausführbare Verfahren beschrieben.

Nach dem Einschalten des Rundfunkempfängers wird dieser durch Betätigung der Taste 18 (Sendersuchlauf) auf ein Programm eingestellt, das den Wünschen des Benutzers entspricht, beispielsweise ein Sender, der Unterhaltungsmusik ausstrahlt. Da der Benutzer Unterhaltungsmusik zu hören wünscht, betätigt er nun die Taste 20, wodurch der Schriftzug "FILTER" aufleuchtet. Zugleich wird in der Steuerschaltung 38 ein Filter gesetzt, wobei in dem Register 42 eine Kennzahl gespeichert wird, die der PTY-Information (Programm-Art) des gerade eingestellten Senders entspricht. Wenn anschließend die Taste 18 zur erneuten Auslösung des Sendersuchlaufs betätigt wird, so wird von jedem gefundenen Sender zunächst die aus den RDS-Daten gewonnene PTY-Information mit der im Register 42 gespeicherten Kennzahl verglichen. Nur bei Übereinstimmung wird der Sendersuchlauf angehalten und der gefundene Sender zum Empfang angeboten. Das Filter bleibt solange aktiv, bis die Taste 20 erneut betätigt wird.

Alle im Sendersuchlauf gefundenen Sender, deren PTY-Information mit der im Register 42 gespeicherten Kennzahl übereinstimmt, werden in dem Senderspeicher 40 gespeichert. Je nach Leistungsfähigkeit des Empfängers 30 kann ein Sendersuchlauf zur Aktualisierung des Inhalts des Senderspeichers 40 kontinuierlich, periodisch oder auch nur bei Bedarf ausgeführt werden. Für jeden im Senderspeicher 40 abgelegten Sender wird zusätzlich eine Qualitätsbewertungsgröße abgespeichert.

Wenn nun die Taste 22 betätigt wird, erfolgt eine Einstellung des Empfängers 30 auf denjenigen unter den im Senderspeicher 40 gespeicherten Sendern, der die beste Empfangsqualität ergibt. Wenn anschließend infolge einer Standortveränderung die Empfangsqualität unbefriedigend wird, kann eine automatische Umschaltung auf einen anderen der im Senderspeicher 40 abgespeicherten Sender erfolgen oder ein erneuter Sendersuchlauf ausgeführt werden.

## Patentansprüche

1. Verfahren zur Abstimmung eines Rundfunkempfängers auf einen Sender einer bestimmten Programm-Art unter Verwendung der RDS-Information, dadurch gekennzeichnet, daß
- der Rundfunkempfänger auf einen beliebigen Sender eingestellt wird, der ein Programm sendet, das den Wünschen des Benutzers entspricht,
- aus der RDS-Information, die der eingestellte Sender mit dem Programm ausstrahlt, die für die Programm-Art kennzeichnende Information (PTY) gewonnen wird,
- durch Betätigung eines zugeordneten Bedienelements (20) ein Filter gesetzt wird, dessen Filterbedingung die Übereinstimmung mit dieser die Programm-Art kennzeichnenden Information ist,
- bei einer anschließenden Einstellung des Rundfunkempfängers auf einen anderen Sender auch dessen die Programm-Art kennzeichnende Information gewonnen wird und
- jeder anschließend eingestellte Sender nur dann als empfangbar berücksichtigt wird, wenn er die Filterbedingung erfüllt.

2. Verfahren nach Anspruch 1, dadurch gekennzeichnet, daß durch erneute Betätigung des Bedienelements die Filterbedingung inaktiviert wird.

3. Verfahren nach Anspruch 2, dadurch gekennzeichnet, daß die Wirksamkeit der Filterbedingung durch ein dem Bedienelement zugeordnetes Anzeigeelement angezeigt wird.

4. Verfahren nach einem der vorstehenden Ansprüche, dadurch gekennzeichnet, daß bei aktiviertem Filter und Durchführung eines Sendersuchlaufs auf einem gefundenen Sender nur dann angehalten wird, wenn er die Filterbedingung erfüllt.

5. Verfahren nach einem der vorstehenden Ansprüche, dadurch gekennzeichnet, daß bei aktiviertem Filter und periodisch oder permanent durchgeführtem Sendersuchlauf ein gefundener Sender nur dann in einer Sendertabelle gespeichert wird, wenn er die Filterbedingung erfüllt.

6. Verfahren nach Anspruch 4 oder 5, dadurch gekennzeichnet, daß durch Betätigung eines gesonderten Bedienelements ein Sendersuchlauf ausgelöst wird, von jedem gefundenen Sender, der die Filterbedingung erfüllt, die Empfangsqualität bestimmt und eine für sie kennzeichnende Bewertungsröße mit der Senderfrequenz vorübergehend gespeichert wird und schließlich unter den gespeicherten Senderfrequenzen diejenige zum Empfang eingestellt wird, deren Bewertungsgröße die beste Empfangsqualität angibt.

## Claims

1. A method for the tuning of a broadcast radio receiver to a transmitter of a determined type program using RDS information, characterized in that
- the broadcast radio receiver is tuned to any transmitter broadcasting a program which meets the wishes of the user,
- from the RDS information, which is broadcast by the tuned in transmitter with the program, the information (PTY) indicating the type of program is obtained,
- by actuation of an associated control element (20) filter is set, whose filter condition is agreement with this information characteristic of such type of program,
- in the course of ensuing tuning of the broadcast radio receiver to another transmitter, information thereof characteristic of the type of program is also obtained and
- each transmitter then tuned in is only taken into account as being suitable for reception if it complies with the filter condition.

2. The method as claimed in claim 1, characterized in that the filter condition is disabled by renewed actuation of the control element.

3. The method as claimed in claim 2, characterized in that the active status of the filter condition is indicated by an indicating element associated with the control element.

4. The method as claimed in any one of the preceding claims, characterized in that when the filter is enabled and a search sweep is being performed such sweep is only halted at a transmitter found thereby when such transmitter fulfills the filter condition.

5. The method as claimed in any one of the preceding claims, characterized in that when the filter is enabled and a search sweep is being performed periodically or continuously a transmitter found is only stored in a transmitter table if it complies with the filter condition.

6. The method as claimed in claim 4 or in claim 5, characterized in that by actuation of a separate control element a transmitter search sweep is started, the reception quality of each transmitter found, which fulfills the filter condition, is determined and an evaluation characteristic thereof is stored with the transmission frequency temporarily, and finally, of the stored transmission frequencies that one is tuned to for reception whose evaluation leads to the best reception quality.

## Revendications

1. Procédé pour accorder un récepteur radio sur un émetteur d'un type déterminé de programme en utilisant l'information RDS, caractérisé en ce que
- le récepteur radio est accordé sur un émetteur quelconque qui émet un programme correspondant aux souhaits de l'utilisateur,
- les informations (PTY) caractéristiques du type de programme sont dérivées de l'information RDS que l'émetteur actuel émet avec le programme,
- par actionnement d'un élément (20) de commande associé, un filtre est activé dont la condition de filtrage est l'identité avec cette information caractérisant le type de programme,
- lors d'un accord subséquent du récepteur radio sur un autre émetteur, l'on dérive aussi l'information caractéristique du type de programme de cet émetteur, et
- chaque émetteur sur lequel l'on accorde ensuite n'est retenu comme recevable que lorsqu'il satisfait à la condition de filtrage.

2. Procédé suivant la revendication 1, caractérisé en ce que la condition de filtrage est inactivée par actionnement renouvelé de l'élément de commande.

3. Procédé suivant la revendication 2, caractérisé en ce que l'état actif de la condition de filtrage est affiché par un élément d'affichage associé à l'élément de commande.

4. Procédé suivant l'une quelconque des revendications précédentes, caractérisé en ce que, en cas de filtre activé et lors de l'exécution d'une recherche d'émetteurs, on ne s'arrête sur un émetteur trouvé que s'il satisfait à la condition de filtrage.

5. Procédé suivant l'une quelconque des revendications précédentes, caractérisé en ce que lorsque le filtre est activé et lors d'une recherche d'émetteurs exécutée de manière périodique ou permanente, un émetteur trouvé n'est enregistré dans un tableau d'émetteurs que lorsqu'il satisfait à la condition de filtrage.

6. Procédé suivant les revendications 4 ou 5, caractérisé en ce qu'une recherche d'émetteurs est lancée par actionnement d'un élément particulier de commande, la qualité de réception de chaque émetteur trouvé satisfaisant à la condition de filtrage est déterminée, et une donnée de pondération caractéristique de cette qualité est temporairement enregistrée avec la fréquence d'émission, et celle des fréquences enregistrées étant finalement retenue pour accord de réception dont la donnée de pondération indique la meilleure qualité de réception.
